# EUROPEAN PATENT SPECIFICATION

(11) **EP 0 474 952 B1**
(45) Date of publication and mention of the grant of the patent: **01.06.1994**
(21) Application number: 90810695.8
(22) Date of filing: 14.09.1990
(51) Int. Cl.: H01S 3/025, H01L 33/00, H01L 21/316, H01L 21/318

(54) **A method of passivating etched mirror facets of semiconductor lasers**
Methode zur Passivierung von geätzten Spiegelfacetten von Halbleiterlasern
Méthode pour la passivation des facettes de miroir gravées de lasers à semi-conducteur

(43) Date of publication of application: 18.03.1992
(73) Proprietor: International Business Machines Corporation, Armonk, N.Y. 10504 (US)
(72) Inventor: Buchmann, Peter, CH-8135 Langnau am Albis (CH); Webb, David J., CH-8803 Rüschlikon (CH); Vettiger, Peter, CH-8135 Langnau am Albis (CH)
(74) Representative: Barth, Carl Otto

(56) References cited:
- EP-A- 0 381 521
- US-A- 4 751 201
- JAPANESE JOURNAL OF APPLIED PHYSICS, vol. 27, no. 7, July 1988, pages L1331-L1333, Tokyo, JP; J.-F. FAN. et al.: "The effect of (NH4)2S treatment on the interface characteristics of GaAs MIS structures"
- JAPANESE JOURNAL OF APPLIED PHYSICS, vol. 28, no. 3, March 1989, pages L340-L342, Tokyo, JP; H. OIGAWA et al.: "Studies on an (NH4)2Sx-treated GaAs surface using AES, LEELS and RHEED"
- JOURNAL OF VACUUM SCIENCE & TECHNOLOGY B, vol. 6, no. 4, July/August 1988, pages 1180-1183, New York, US; C.W. WILMSEN et al.: "Characterization of photochemically unpinned GaAs"
- APPLIED PHYSICS LETTERS, vol. 54, no. 3, 16th January 1989, pages 213-215, New York, US; M.G. MAUK et al.: "Study of novel chemical surface passivation techniques on GaAs pn junction solar cells"

## Description

### TECHNICAL FIELD

The invention concerns a method of passivating etched mirror facets of semiconductor laser diodes for enhancing device reliability. This is accomplished by reducing minority carrier recombination at the mirror interfaces and thus the development of heat which otherwise causes degradation particularly at high optical output power.

### BACKGROUND OF THE INVENTION

With the ever-growing importance of III-V compound semiconductor laser diodes in applications such as optical communications, printers and optical disk memory systems, there is a high demand for devices with high reliability providing for long lifetime coupled with high power capabilities. Usually the maximum optical output power is limited by the catastrophic optical damage (COD) or output power saturation due to local heating at the laser mirrors. It is thus important that the COD level be raised by optimizing the mirror passivation to reduce heat development near the mirror interface.

Hitherto, most laser diodes used have cleaved mirrors resulting in excellent performance and yielding high reliability and long lifetimes at high optical power provided a proper passivation coating is applied to the mirror facets.

More recently, however, much attention has been directed to etched mirror devices, mainly because of the inherent advantages of this technology allowing full wafer processing and testing and a high level of integration. A typical device and a method for its fabrication is disclosed in the published European patent application 0 363 547 "Method for Etching Mirror Facets of III-V Semiconductor Structures". However, for etched mirrors it is more difficult to achieve the required reliability and lifetimes at the necessary output power. There is a definite need for improved devices.

It has long been recognized that III-V compound surfaces, GaAs having been most widely studied, are generally of a poor electronic quality whereby the use of these materials in optoelectronic applications has been limited. Considerable efforts have been made aiming at an understanding of the mechanism causing the problems leading to mirror heating and performance degradation. Today it is generally believed that the problems be mainly caused by native oxides at the mirror interface, these oxides accounting for the large number of non-radiative recombination centers which, in turn, cause heating at the mirror facets.

Recently, a passivation method involving a sodium sulfide nonahydride (Na₂S.9H₂O) treatment has been found to favorably impact GaAs surface properties, one aspect being the reduction of minority carrier recombination centers. The key step of this method is the removal of native oxides from the semiconductor surface. Once Ga₂O₃ and As₂O₃ have been dissolved by the highly alkaline sulfide solution, the sulfur neutralizes the surface electronic states that otherwise form efficient recombination centers for minority carriers.

The effects and results so far achieved with such sulfide treatments have been investigated and discussed in a number of publications, a few of which are listed below:
- "Structure and Stability of Passivating Arsenic Sulfide Phases at GaAs Surfaces" by C.J. Sandroff et al. (J. Vac. Sci. Technol. B7 (4), July/August 1989, pp.841-843). Described are the results of an investigation on the use of aqueous sulfides on GaAs surfaces. Examined were the structure and degradation mechanism of the passivating phases formed during treatment with the aqueous sulfide. Degradation was found to take place in the presence of oxygen and light, producing a surface composed primarily of As₂O₃. It is shown that long lasting passivation could be achieved if either light or oxygen is excluded.
- "Study of Novel Chemical Surface Passivation Techniques on GaAs pn Junction Solar Cells" by M.G. Mauk et al. (Appl. Phys. Lett. 54 (3), 16 January 1989, pp.213-215). This is a report on an investigation of GaAs surface passivation methods wherein passivation is achieved by chemical treatments using aqueous solutions of Na₂S, KOH, RuCl₃ and K₂Se. Solar cell structures are used to evaluate the effectiveness of these passivation techniques.
- "Effects of Passivating Ionic Films on the Photoluminescence Properties of GaAs" by B.J. Skromme et al. (Appl. Phys. Lett 51 (24), 14 December 1987, pp.2022-2024). Described are studies of passivating effects of spin-coated Na₂S.9H₂O on GaAs surfaces. Photoluminescence methods are employed to characterize non-radiative surface recombination. After passivation, the photoluminescence was found to be increased, the surface field and surface recombination-related notch features eliminated.
- "Raman Scattering Measurements of Decreased Barrier Heights in GaAs following Surface Chemical Passivation" by L.A. Farrow et al. (App. Phys. Lett. 51 (23), 7 December 1987, pp.1931 ff).
   Raman scattering is used to provide a quantitative, contactless way of measuring the reduced barrier height associated with decreased density of GaAs surface states obtained by treating GaAs surfaces with thin films of sodium sulfide nonahydride (Na₂S.9H₂O).

Applicant is not aware of any publication disclosing or suggesting the application of such pre-passivation treatment in the fabrication of etched mirrors to improve laser reliability. This is surprising in view of the earlier work on the results of such sulfide treatments with respect to achievable electronic property modifications of GaAs surfaces, and because the need for improved mirror facets has long been recognized.

As will be hereinafter described, the use of such pre-passivation treatment in combination with a preceding wet-etch "cleaning" process and the subsequent deposition of a final passivation coating permanently preventing any chemical reaction at the mirror facet, provides for etched mirror laser devices of extremely high and unexpected lifetimes at optical powers not hitherto achieved for any extended period of time.

### SUMMARY OF THE INVENTION

It is a main object of the invention to provide a method for the fabrication of etched mirror laser diodes resulting in devices of greatly improved reliability and long lifetimes at high optical output powers.

Another object is to provide a method of passivating etched mirror interfaces that serves to remove the detrimental oxides and to reduce non-radiative minority carrier recombination at the mirror interfaces, and provides a chemically stable passivation preventing the diffusion of species capable of reacting with the mirror surface over the lifetime of the devices.

The invention as claimed in claim 1 is intended to meet these objectives and to remedy the deficiencies of known laser mirror passivation techniques. The inventive method provides the desired improvement in that the etched mirror facet is first subjected to a wet-etch process to substantially remove any native oxide as well as any surface layer which may have been mechanically damaged during the preceding mirror etch process. Then, a passivation pre-treatment is applied whereby any residual surface oxide is removed and, most important, a sub-monolayer is formed which permanently reduces the non-radiative recombination of minority carriers at the mirror facet. Finally, the pre-treated mirror surface is coated with a passivation layer to avoid any environmental effects on the mirror.

The main advantages offered by the invention are that the major long-term reliability problems of etched mirror lasers are eliminated or at least largely reduced: residues, damaged crystals and oxide films are removed from the mirror facets causing, with the proposed passivation applied, a permanent reduction of recombination centers. This results in substantially less heat developing at the mirrors and thus in a large increase in device lifetime and power capabilities while maintaining the optical mirror quality.

### DESCRIPTION OF THE DRAWING

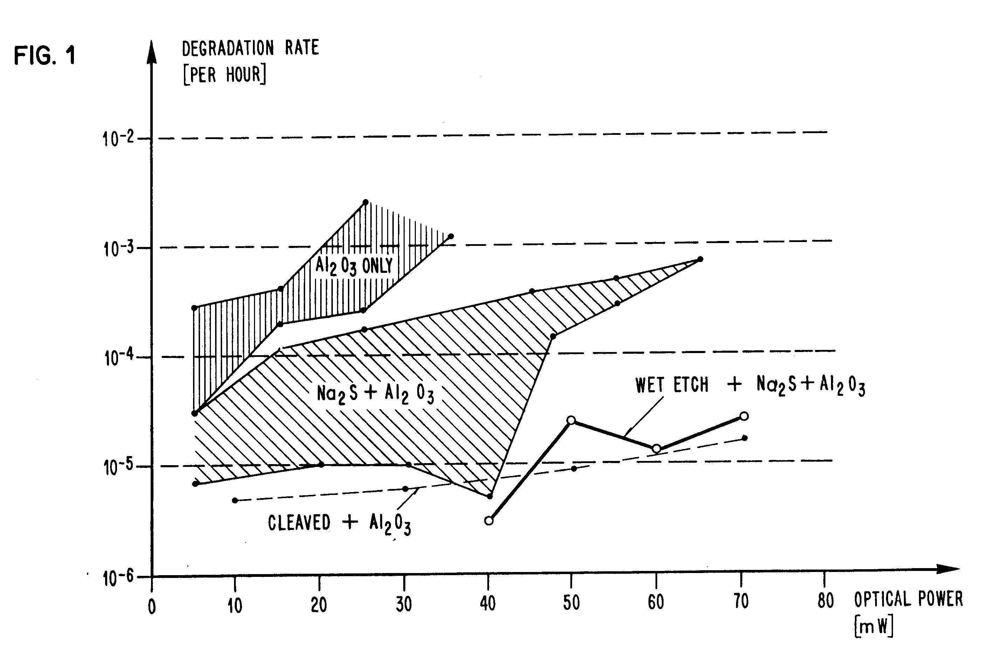

The invention is described in detail below with reference to a diagram which serves to demonstrate the improvement in laser performance that is achievable when applying the inventive method. Fig. 1, representing the diagram, shows, for various laser types, the degradation rate of the laser drive current, needed to maintain a constant output power, as a function of the output power.

### DETAILED DESCRIPTION

Before describing an embodiment of the invention in greater detail, the problems generally occurring in etched mirror laser diode fabrication will be briefly outlined with reference to devices produced in GaAs technology.

Mirror etching is usually done by reactive ion etching (RIE), by reactive ion beam assisted etching (RIBAE), or by chemically assisted ion beam etching (CAIBE). A suitable process has been described in published European Patent Application 0 363 547.

With etched mirrors so obtained, there are a number of problems affecting the performance of the fabricated devices, particularly with respect to the long-term reliability. These problems are caused by and dependent on mirror surface conditions which may be affected by
- crystal damage caused by ion bombardment;
- oxide films resulting from an ashing step used to remove the photoresist mask;
- residues from the etching process, e.g., chlorides; and/or
- surface roughness due to non-ideal etch mask edges.

In addition, there exists a general problem inherent when producing GaAs devices since oxygen-exposed GaAs and AIGaAs surfaces show a large increase in the non-radiative recombination rate at surface recombination centers. This severely limits the device performance.

In using the inventive passivation method, the above problems are eliminated or substantially reduced. The method comprises three successive processes that will now be described.

In the embodiment chosen for the description of the inventive method, starting point is an almost completed layered GaAs/AIGaAs laser structure, e.g., a graded index separate confinement heterostructure (GRINSCH) device with etched mirror facets defining the length of the laser cavity. It could be produced using the method described in the above mentioned European Patent Application 0 363 547 followed by an ashing step used to remove the photoresist etch mask.

In a first process step, the mirror facets are subjected to a wet chemical treatment for "cleaning" the mirror surfaces and to remove any surface layer of the semiconductor crystal which may have been mechanically damaged by the ion-bombardment during the mirror etch process. The etchant is chosen so as to minimize the etch rate difference of the GaAs/AIGaAs layers as a function of AI concentration, and also to produce a relatively slow, well-controlled etch rate so that about 20 nm to 30 nm of material can be reproducible removed. Suitable for this purpose is an etchant of H₂SO₄ / H₂O₂ / H₂O in the proportion 1 : 8 : 1000 used at room temperature for about 20 seconds. A possible alternative would be a Br/CH₃OH etchant. The sample is then rinsed in DI-water and dried with nitrogen.

The next step is a passivation pre-treatment applied to remove residual surface oxides which might remain after the wet-etch step, and to thereby reduce the number of minority carrier recombination centers at the mirror interface.

This is done by spinning onto the sample a solution of 1M Na₂S in water (e.g. Na₂S.9H₂O). This solution dries to form a crust. The wafer may then be baked at typically 100 to 250° C for about 10 to 20 minutes. The crust is then removed with a water rinse for one minute, blown dry with N₂ and quickly transferred to a vacuum system where permanent passivation coating is applied to the mirrors using vacuum deposition method.

The effect of the treatment with the aqueous Na₂S solution is supposed to be that surface oxides are removed and replaced with a sub-monolayer coverage of sulfides. The sulfide bonds are considered to be less efficient non-radiative recombination centers than oxide bonds would be. This reduced non-radiative recombination then leads to improved mirror reliability since the heating at the mirror facets is reduced.

For this pre-treatment, aqueous solutions other than Na₂S can be used, e.g., a solution of (NH₄)₂S.

The benefits derived from terminating the mirror surfaces with the sub-monolayer is temporary unless a permanent passivating layer is applied. Without such passivation, protection will be degrading within several hours, depending on environmental conditions.

To obtain a permanently stable interface, a passivation coating is subsequently applied using any conventional vacuum deposition method. For long-term protection, this coating should consist of a material that does not contain oxygen that could form native oxides with the semiconductor material or not react itself with the mirror interface, and that prevents the diffusion of species capable of reacting with the mirror surface. Al₂O₃ was found to provide good results, Si₃N₄ being a possible alternative. The passivation coating can also be in the form of layers applied to modify the interface reflectivity.

The diagram of Fig. 1 shows the life test data for three kinds of etched mirror lasers. The data for passivated, cleaved mirror lasers are included for comparison.

The data show how the degradation rate of the drive current, needed to maintain a constant output power, varies with output power, low degradation rates obviously being indicative of a long device life at the respective output power. The requirements are for a rate of change in drive current of the order 10⁻⁶ to 10⁻⁵ per hour, at high (above 40 mW) output powers, for several thousand hours. Data are shown for three different etched mirror treatments.

Lasers with dry etched mirrors which have simply been coated with sputtered Al₂O₃ (area marked "Al₂O₃ only") degrade rapidly at powers as low as 20 mW and would not be acceptable for most applications. Lasers which have received the Na₂S treatment after dry etching but before coating ("Na₂S + Al₂O₃") are already much better. They have lower degradation rates at up to about 40 mW. Lasers which have received both, the wet-etch and then the Na₂S treatment after dry mirror etching but before coating are the best of all ("Wet etch + Na₂S + Al₂O₃"). The data on these lasers are almost comparable to cleaved mirror lasers ("Cleaved + Al₂O₃"). They have low degradation rates at 40 mW and lifetimes of several hundred hours at 60 to 70 mW.

Experiments have shown that at output powers of about 5 mW and below the quality of the mirror passivation can be quite poor without significantly impacting the degradation rate. However, at powers of about 30 mW and above, the mirrors degrade very rapidly unless they are correctly passivated.

The data shown for etched mirror lasers produced in accordance with the inventive passivation method represent a very considerable improvement in etched mirror technology. It was totally unexpected that applying the wet-etch process prior to the Na₂S treatment and then coating the mirror interface with a conventional passivation layer, would result in such benefits. Presently, only these improvements allow the desired broader use of etched mirror lasers in important application fields that are currently "reserved" for the traditional cleaved mirror devices.

## Claims

1. A method of passivating etched mirror facets of semiconductor laser diodes for enhancing device reliability, comprising the steps of:
- wet-etching the surfaces of said etched mirror facets to substantially remove any native oxide as well as any surface layer which may have been mechanically damaged during the preceding mirror etch process,
- applying a passivation pre-treatment to remove any residual surface oxide and to form a sub-monolayer of a material that remains chemically stable during device lifetime and which substantially reduces the number of non-radiative minority carrier recombination centers at the mirror facet, and
- coating the pre-treated mirror facet with a passivation layer consisting of a material not reacting itself with the mirror facet interface, and preventing the diffusion of species capable of reacting with the mirror facet interface.

2. A method as claimed in claim 1, wherein the etchant used in said wet-etching step exhibits a minimal etch-rate difference for the semiconductor materials exposed at the mirror facets.

3. A method as claimed in claim 2, wherein the etchant consists of H₂SO₄ / H₂O₂ / H₂O in the proportions 1 : 8 : 1000.

4. A method as claimed in claim 1, wherein an aqueous Na₂S solution is used in said pre-treatment step.

5. A method as claimed in claim 1, wherein an aqueous (NH₄)₂S solution is used in said pre-treatment step.

6. A method as claimed in claim 4, wherein said pre-treatment consists of
- spinning said Na₂S solution onto the wet-etched mirror facets,
- drying the solution to form a crust,
- baking the laser structure at 100 to 250° C,
- removing of the crust, and
- drying the pre-treated mirror facets.

7. A method as claimed in claim 1, wherein the coated passivation layer consists of Al₂O₃.

8. A method as claimed in claim 1, wherein the coated passivation layer consists of Si₃N₄.

## Patentansprüche

1. Verfahren zum Passivieren geätzter Spiegelflächen von Halbleiterlaserdioden zur Steigerung der Zuverlässigkeit des Bauelements, das die folgenden Schritte umfaßt:
- Naßätzen der Oberflächen der geätzten Spiegelflächen, um im wesentlichen sowohl jegliches natürliche Oxid als auch jegliche Oberflächenschicht zu entfernen, die während des vorhergehenden Ätzprozesses des Spiegels möglicherweise mechanisch beschädigt wurde,
- Anwenden einer Passivierungs-Vorbehandlung, um jegliches übriggebliebenes Oberflächenoxid zu entfernen und eine Submonoschicht aus einem Material zu bilden, das während der Lebensdauer des Bauelements chemisch stabil bleibt und die Anzahl an nichtstrahlenden Minoritätsladungsträger-Rekombinationszentren an der Spiegelfläche wesentlich reduziert, und
- Beschichten der vorbehandelten Spiegelfläche mit einer Passivierungsschicht, die aus einem Material besteht, das nicht selbst mit der Spiegelflächengrenzfläche reagiert und das die Diffusion von Bestandteilen verhindert, die dazu in der Lage sind, mit der Spiegelflächengrenzfläche zu reagieren.

2. Verfahren nach Anspruch 1, wobei das in dem Naßätz-Schritt verwendete Äzmittel eine minimale Ätzratendifferenz für die an den Spiegelflächen freiliegenden Halbleitermaterialien aufweist.

3. Verfahren nach Anspruch 2, wobei das Ätzmittel aus H₂SO₄ / H₂O₂ / H₂O in den Anteilen 1 : 8 : 1000 besteht.

4. Verfahren nach Anspruch 1, wobei in dem Vorbehandlungsschritt eine wässerige Na₂S-Lösung verwendet wird.

5. Verfahren nach Anspruch 1, wobei in dem Vorbehandlungsschritt eine wässerige (NH₄)₂S-Lösung verwendet wird.

6. Verfahren nach Anspruch 4, wobei die Vorbehandlung aus folgenden Schritten besteht:
- Aufschleudern der Na₂S-Lösung auf die naßgeätzten Spiegelflächen,
- Trocknen der Lösung, um eine Kruste zu bilden,
- Trocknen der Laserstruktur bei 100 °C bis 250 °C,
- Entfernen der Kruste und
- Trocknen der vorbehandelten Spiegelflächen.

7. Verfahren nach Anspruch 1, wobei die aufgebrachte Passivierungsschicht aus Al₂O₃ besteht.

8. Verfahren nach Anspruch 1, wobei die aufgebrachte Passivierungsschicht aus Si₃N₄ besteht.

## Revendications

1. Procédé de passivation des facettes d'un miroir attaqué chimiquement de diodes laser semiconductrices pour améliorer la fiabilité du dispositif, comprenant les étapes suivantes:
- attaque par réactif liquide des surfaces desdites facettes du miroir attaqué chimiquement pour retirer sensiblement tout oxyde à l'état natif ainsi que toute couche de surface qui peut avoir été mécaniquement endommagée au cours du processus précédent d'attaque chimique du miroir,
- application d'un pré-traitement de passivation pour retirer tout oxyde résiduel de surface et pour former une sous-monocouche d'un matériau qui reste chimiquement stable au cours de la durée de vie du dispositif et qui réduit sensiblement le nombre de centres de recombinaison des porteurs minoritaires non radiants à la facette du miroir, et
- revêtement de la facette du miroir pré-traitée avec une couche de passivation consistant en un matériau ne réagissant pas lui-même avec l'interface de la facette du miroir, et empêchant la diffusion d'espèces capables de réagir avec l'interface de la facette du miroir.

2. Procédé selon la revendication 1, dans lequel le réactif d'attaque utilisé dans ladite étape d'attaque par réactif liquide présente une différence de taux d'attaque minimale pour les matériaux semiconducteurs exposés sur les facettes du miroir.

3. Procédé selon la revendication 2, dans lequel le réactif d'attaque consiste en H₂SO₄ / H₂O₂ / H₂O dans les proportions de 1 : 8 : 1000.

4. Procédé selon la revendication 1, dans lequel une solution aqueuse de Na₂S est utilisée dans ladite étape de pré-traitement.

5. Procédé selon la revendication 1, dans lequel une solution aqueuse de (NH₄)₂S est utilisée dans ladite étape de pré-traitement.

6. Procédé selon la revendication 4, dans lequel le pré-traitement consiste en
- la rotation de ladite solution de Na₂S sur les facettes du miroir attaqué par un réactif liquide,
- le séchage de la solution pour former une croûte,
- la cuisson de la structure laser à une température comprise entre 100 et 250°C,
- le retrait de la croûte, et
- le séchage des facettes du miroir pré-traité.

7. Procédé selon la revendication 1, dans lequel la couche de passivation appliquée consiste en Al₂O₃.

8. Procédé selon la revendication 1, dans lequel la couche de passivation appliquée consiste en Si₃N₄.
